# EUROPEAN PATENT APPLICATION

(11) **EP 2 023 403 A1**
(43) Date of publication of application: **11.02.2009**
(21) Application number: 06756548.1
(22) Date of filing: 24.05.2006
(51) Int. Cl.: H01L 31/10

(54) **ULTRAVIOLET PHOTOSENSOR**

(71) Applicant: Meijo University, Nagoya-shi, Aichi 4688-502 (JP)
(72) Inventor: IWAYA, Motoaki, Inazawa-shi Aichi 495-0014 (JP); KAMIYAMA, Satoshi, Nagoya-shi Aichi 468-0004 (JP); AMANO, Hiroshi, Nagoya-shi Aichi 465-0011 (JP); AKASAKI, Isamu, Nagoya-shi Aichi 451-0061 (JP)
(74) Representative: von Hellfeld, Axel
(86) International application number: PCT/JP2006/310342
(87) International publication number: WO 2007/135739

(57) **Abstract**

In an ultraviolet light receiving element using a group III nitride semiconductor, the ultraviolet light receiving element having an enhanced light receiving sensitivity is provided. An electron is excited from a valence band to a conduction band 61 by means of a depleted layer generated by irradiating a light having energy larger than band gap energy of an undoped layer 44, and electron - hole pairs are generated. A band structure is varied by the generated electron - hole pairs, and thus a portion having an energy lower than that of a quasi - Fermi level 62 of an electron at a boundary between an undoped layer 43 and the undoped layer 44, so that a two-dimensional electron gas 63 is formed. Since the two-dimensional electron gas 63 mentioned above serves as a channel, a large current is flowed by applying a voltage between drain electrode 46 - source electrode 7.

## Description

### TECHNICAL FIELD

The present invention relates to an ultraviolet light receiving element using a group III nitride semiconductor.

### RELATED ART

As an ultraviolet light receiving element, there are existing devices such as phototube, photodiode using Si, phototransistor and so on. However, the phototube has a drawback on a cost, a lifetime and so on, and, the photodiode using Si and the phototransistor have a drawback such that sensitivity is extraordinarily lowered when a wavelength is shortened. Moreover, in the case of using the light receiving element as a flame sensor, it is necessary to arrange the flame sensor near a flame. Therefore, in the case of using a material having lower band gap energy like Si, a limitation due to use environment, such as an increase of dark current by means of a thermal excitation, is burdened.

In order to overcome the drawbacks mentioned above, pin photodiode (for example, patent literature 1), phototransistor (for example, patent literature 2), MSM type photodiode (for example, patent literature 3) and so on are proposed recently, which use a group III nitride semiconductor (GaN, AlN, InN and its mixed crystal) of a wide gap semiconductor.

Since these devices use the wide gap semiconductor i.e. group III nitride semiconductor, they have features: such that a dark current that effects for Si largely can be decreased; such that an absorption at a portion other than a light absorption layer such as a p-type layer can be suppressed; and such that a sensitivity can be enhanced. Moreover, since use is made of a semiconductor, it is expected that a low cost can be realized as compared with the phototube and that a long lifetime can be realized.

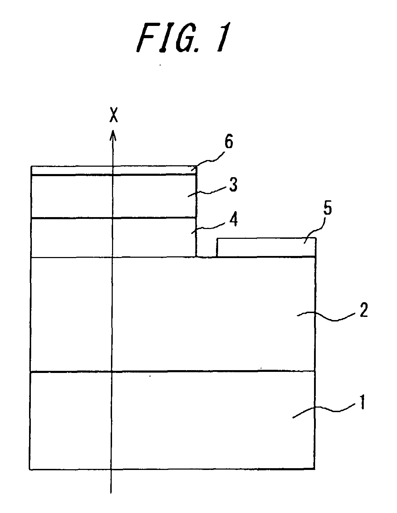

For example, a pin photodiode structure that is typically an example of group III nitride semiconductor light receiving element is shown in Fig. 1. In this structure, on a substrate 1, an i-layer 4 in which impurity is intentionally added is sandwiched between an n-type layer 2 formed by adding Si and a p-type layer 3 formed by adding Mg. As the n-type layer 2, the p-type layer 3 and the i-layer 4, use is made of GaN, AlGaN and AlN respectively, and a material is selected in accordance with a wavelength region to be applied.

Moreover, as the substrate 1, use is made of sapphire or SiC in many cases. In the case of sapphire, use is made of a low-temperature buffer layer, and in the case of SiC, use is made of a high-temperature buffer layer, so that high quality GaN or AlGaN can be obtained. Further, in the manufactured device, an n-type electrode 5 and a p-type electrode 6 are formed on the n-type layer 2 and the p-type layer 3 respectively.

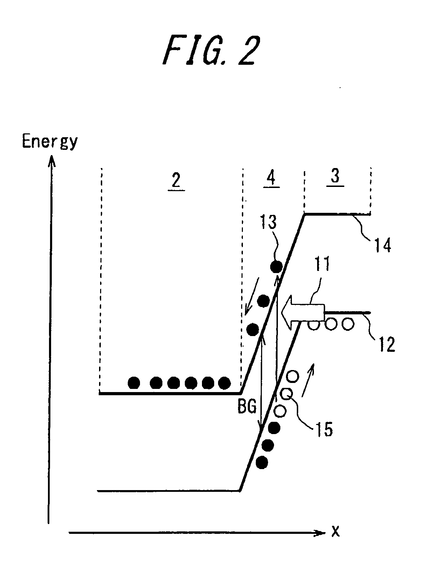

Then, a principle of operation of this device will be explained. Fig. 2 is a band diagram showing X direction of Fig. 1 along a horizontal axis and an energy of electron along a longitudinal axis. In this device, a reverse bias or a zero bias is generally used for the p-type layer 3 and the n-type layer 2. In this case, a depleted layer is widely formed to all the i-layer 4 and a part of the n-type layer 2 and the p-type layer 3.

Under such a condition, if a light 11 having energy larger than a band gap energy BG is incident, an electron 13 existing in a valence band is exited in a conduction band 14. Then, due to the reverse bias and diffusion potential, the electron 13 is diffused in the n-type layer 2 and an electron hole 15 is diffused in the p-type layer 3, so that a current is flowed. In this manner, it is possible to receive selectively the light having energy larger than the band gap energy BG.

Moreover, as explained previously, since GaN and AIGaN have a wide gap and are chemically stable, they can be used near the flame for example and thus it is possible to apply them to an application such as a flame sensor. Moreover, if a material having wide gap energy as compared with the i-layer 4 is selectively used for the p-type layer 3 and the n-type layer 2, it is possible to receive selectively a light only by the i-layer 4 and thus a device having a high sensitivity can be manufactured.

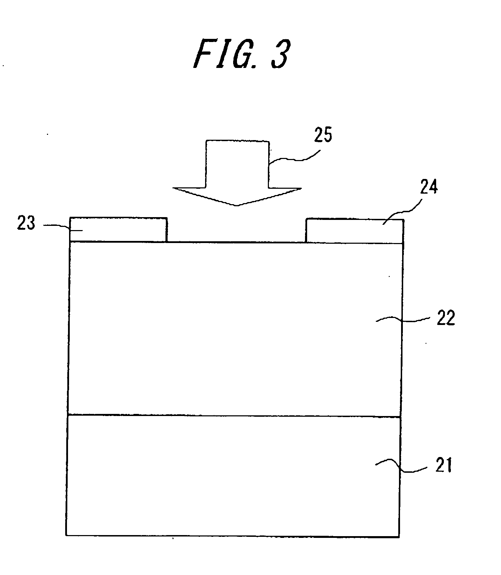

Then, the MSM-type photodiode will be explained. A schematic view of the typical MSM-type photodiode is shown in Fig. 3. On a substrate 21, an undoped layer 22 made of GaN or AlGaN is formed. After that, a first electrode 23 and a second electrode 24 are formed. Under a condition such that a bias is applied to the first electrode 23 and the second electrode 24, which are formed to this semiconductor, if a light 25 is irradiated, the electron in the valence band is exited in the conduction band due to its light energy. A current is flowed by moving the exited electron and an electron hole in the valence band generated by an electron drop, and thus this device can be operated as the ultraviolet light receiving element by measuring the flowed current.

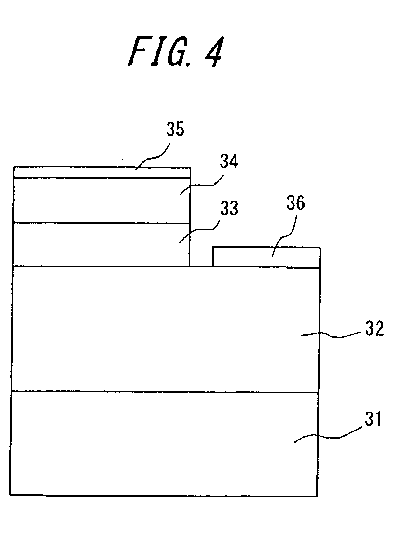

Moreover, an npn phototransistor is proposed as shown in Fig. 4. The npn phototransistor mentioned above comprises: a substrate 31; a first n-type layer 32 formed thereon; a p-type layer 33 formed thereon; a second n-type layer 34 formed thereon; an emitter electrode 35 formed thereon; and a collector electrode 36 formed on the first n-type layer 32. In the npn transistor, this structure is designed to receive a light on a base layer, and an electron-hole pair generated due to a light irradiation serves as a base current, so that it is possible to receive a light.

As mentioned above, an investigation of the light receiving element using group III nitride semiconductor is widely performed, but there remains a large drawback. In the pin photodiode and the MSM photodiode, especially large drawback is that a light current to be obtained is extraordinarily low. For example, in the case of detecting a flame, it is necessary to receive a light of a few microwatts. However, in these structures, even if all energy of its light is received by a light receiving layer and is converted into a current, only a weak current such as a few microamperes is obtained.

Moreover, an application for the other ultrasonic light receiving elements has the same drawbacks. In the case of the npn phototransistor, there exists no high-performance device in the transistors using group III nitride semiconductors at present, and thus there exists no high-performance device even in the phototransistors. That is, in the ultraviolet light receiving element using group III nitride semiconductor, it is required to realize an ultraviolet light receiving element having high light receiving sensitivity. Such ultraviolet light receiving element having high light receiving sensitivity is expected to be applied for a flame sensor, a medical sensor and so on, and a device using GaN/AlGaN heterostructure is proposed (for example, nonpatent literature 1).
Patent Literature 1: Japanese Patent Laid-Open Publication No. 2003-23175
Patent Literature 2: Japanese Patent Laid-Open Publication No. 9-229763
Patent Literature 3: Japanese Patent Laid-Open Publication No. 2003-23175
Nonpatent Literature 1: M. A. Khan, M. S. Shur, Q. C. Chen, J. N. Kuznia and C. J. Sun: Electronics Letters, Vol. 31 (1995) p/398-400.

### DISCLOSURE OF THE INVENTION

### TASK TO BE SOLVED BY THE INVENTION

However, even in the ultraviolet light receiving element using GaN/AlGaN heterostructure, it is difficult to realize an excellent light-dark ratio, and thus it is difficult to make a light receiving sensitivity higher.

An object of the present invention is to provide an ultraviolet light receiving element, which makes a light receiving sensitivity higher, in the ultraviolet light receiving element using group III nitride semiconductor.

### MEANS FOR SOLVING THE TASK

According to the invention, an ultraviolet light receiving element comprises:
a substrate;
a first layer formed by a GaN group semiconductor and arranged on said
substrate;
a second layer having the same conductive type as that of said first layer, which is formed by a GaN group semiconductor to be contacted with said first layer and to include a source region, a drain region and a channel region; and
a third layer having a p-type, which is formed by a GaN group semiconductor to be contacted with said second layer and to include a gate region.
In this specification, a term "GaN group semiconductor" means GaN, AlN, InN and a mixed crystal including them.

### EFFECT OF THE INVENTION

According to the invention, in the case such that a light having energy larger than the band gap energies of the first layer, the second layer and the third layer is not incident upon the ultraviolet light receiving element, a part of the first layer and the second layer becomes a depleted layer due to the third layer, and there is no portion having energy lower than a quasi-Fermi level of electron. Under such a condition, if a voltage is applied between source and drain, a current is not almost flowed.

In the case such that a light having energy larger than the band gap energies of the first layer, the second layer and the third layer is incident upon the light receiving element, an electron is exited from the valence band to the conduction band due to the depleted layer, so that the electron-hole pair is generated. A band structure is changed due to the electron-hole thus generated, and then a portion having energy lower than a quasi-Fermi level is generated at a boundary between the first layer and the second layer, so that a two-dimensional electron gas is formed. Since the thus formed two-dimensional electron gas serves as a channel, a current is flowed between source and drain.

In the present invention, the pn junction is formed and a control is performed by irradiating a light to the depleted layer formed by the structire mentioned above, so that a high-performance ultraviolet light receiving element can be realized. Moreover, in this case, if use is made of the two-dimensional electron gas or a vertical conduction, a high-performance i.e. a high-sensitive ultraviolet light receiving element can be realized. Further, a conductivity type of the first layer and a conductivity type of the second layer can be made same (i.e. the second layer is made to p-type when the first layer is p-type, and the second layer is made to n-type when the first layer is n-type), and a sufficient light-dark ratio can be realized by making the third layer to p-type, so that a sensitivity of the high-sensitive ultraviolet light receiving element can be further improved. In this case, when the first layer is constructed by GaN and the second layer is constructed by AlGaN to form GaN/AIGaN hetero junction between the first layer and the second layer, the depleted layer is further liable to be generated.

By doping the second layer, it is possible to increase an amount of the two-dimensional electron gas generated when a light having energy larger than the band gap energies of the first layer, the second layer and the third layer, and thereby properties of the ultraviolet light receiving element can be further improved. In this case, it is further effective that an undoped spacer layer intervenes in the second layer, or, a quantum well structure or a heterostructure is formed in the second layer.

If an optical confinement structure is formed, it is possible to further improve the properties of the ultraviolet light receiving element. In this case, the optical confinement structures may be constructed by a semiconductor DBR or a dielectric multiplayer. In order to extend the depleted layer toward the undoped layer, it is necessary to make a carrier density ratio between the p-layer and the n-layer larger, and it is important to make a carrier density difference over double digits. Therefore, it is preferred that the first layer is made to be an undoped layer or a layer having a doped density of not more than 1×10¹⁸ cm⁻³ and that the third layer is made to be an acceptor density of not less than 1×10¹⁸ cm⁻³.

### BRIEF DESCRIPTION OF THE DRAWINGS

[Fig. 1] Fig. 1 is a schematic view showing a known structure of pin photodiode made of group III nitride semiconductor.
[Fig. 2] Fig. 2 is a band diagram in the element structure shown in Fig. 1.
[Fig. 3] Fig. 3 is a schematic view illustrating a known structure of MSM photodiode made of group III nitride semiconductor.
[Fig. 4] Fig. 4 is a schematic view depicting a conventionally disclosed npn phototransistor made of group III nitride semiconductor.
[Fig. 5] Fig. 5 is a schematic view showing an element structure of a first embodiment of an ultraviolet light receiving element according to the invention.
[Fig. 6] Fig. 6 is a schematic view illustrating energy distribution of a conduction band located directly below a p-type layer of Fig. 5, under a condition such that a light having energy larger than band gap energy of the p-type layer is not incident.
[Fig. 7] Fig. 7 is a schematic view depicting energy distribution of a conduction band located directly below a p-type layer of Fig. 5, under a condition such that a light having energy larger than band gap energy of an undoped layer 44 is incident.
[Fig. 8] Fig. 8 is a schematic view showing a relation between source-drain voltage and source-drain current of the ultraviolet light receiving element according to the first embodiment.
[Fig. 9] Fig. 9 is a schematic view illustrating a relation between source-drain voltage and source-drain current of the ultraviolet light receiving element in the case that no p-type layer is used.
[Fig. 10] Fig. 10 is a schematic view depicting an element structure of a second embodiment of an ultraviolet light receiving element according to the invention.

### EXPLANATION OF SYMBOLS

- 1, 21, 31, 41, 71: substrate
- 2, 32, 34, 73, 76: n-type layer
- 3, 33, 45, 74: p-type layer
- 4: i layer
- 5: n electrode
- 6: p electrode
- 11, 25: light
- 12: valence band
- 13: electron
- 14, 51, 61: conduction band
- 15: electron hole
- 22, 43, 44, 75: undoped layer
- 23, 24: electrode
- 35: emitter electrode
- 36: collector electrode
- 42, 72: buffer layer
- 46, 77: drain electrode
- 47, 79: source electrode
- 48, 78: gate electrode
- 52, 62: quasi-Fermi level
- 63: two-dimensional electron gas
- BD: band gap

### BEST MODE FOR CARRYING OUT THE INVENTION

An embodiment of an ultraviolet light receiving element according to the invention will be explained in detail with reference to the drawings.

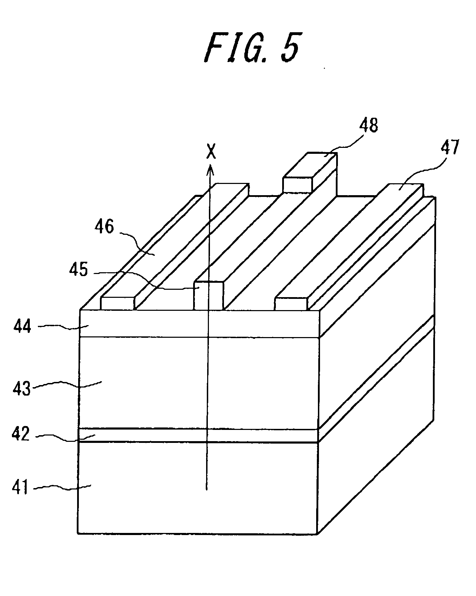

Fig. 5 is a schematic view showing an element structure of a first embodiment of the ultraviolet light receiving element according to the invention. When the ultraviolet light receiving element mentioned above is manufactured, on a substrate 41 (for example, sapphire substrate), a crystal growth of a buffer layer 42 (for example, low-temperature AlN buffer layer) is performed at about 500 °C by means of a method such as organometal compound vapor growth method, and a crystal growth of an undoped layer 43 (for example, undoped GaN layer) with about 2 µm thickness is performed at about 1000 °C.

After that, an undoped layer 44 (for example, undoped AlGaN layer) is laminated by 15 nm, and a p-type layer 45 (for example, p-type GaN layer) having a hole carrier density of 1 ×10¹⁸ [cm⁻³] and an acceptor density of 3×10¹⁹ [cm⁻³], which is obtained by adding Mg, is laminated by 20 nm. After a heat treatment is performed in nitride atmosphere at 700 °C for 5 minutes with respect to a specimen manufactured in this manner, an element isolation is performed.

After that, a mask (for example, Ni mask) is deposited on a part of the p-type layer 45 by using a photolithography technique, and the p-type layer 45 is completely etched by using a reactive ion etching device utilizing for example chlorine plasma. Then, the undoped layer 45 is exposed, and the mask is removed by using a liquid such as nitric acid.

After that, a drain electrode 46 and a source electrode 47 both made of for example Ti/Al are formed on a surface of the exposed undoped layer 44 by using a photolithographic technique. After that, a gate electrode 48 made of for example Ni/Au is formed on a part of the p-type layer 45. In the ultraviolet light receiving element manufactured in this manner, a heterostructure is formed between the undoped layer 43 and the undoped layer 44, and, between the undoped layer 44 and the p-type layer 45.

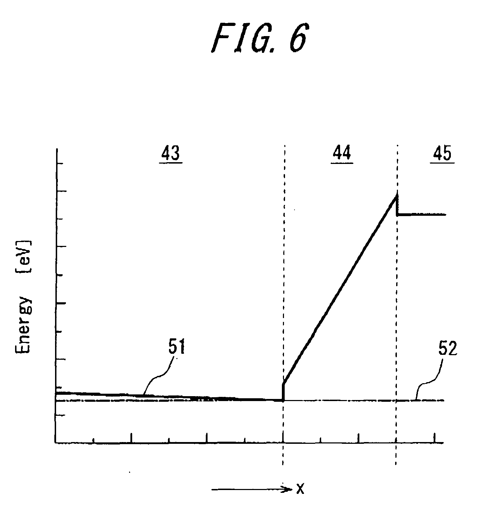

Fig. 6 is a schematic view showing energy distribution of a conduction band 51 located directly below the p-type layer of Fig. 5. In this case, a light having energy larger than the band gap energies of the undoped layers 43, 44 and the p-type layer 45 as a material is not incident upon the ultraviolet light receiving element, and data at room temperature are shown.

In Fig. 6, a horizontal axis shows an X direction shown in Fig. 5, and a longitudinal axis shows electron energy. If the conduction band 51 in Fig. 6 is paid attention, a part of the undoped layers 44 and 43 becomes a depleted layer due to the p-type layer 45, and there is no portion having energy lower than a quasi-Fermi level 52 of electron. Therefore, if a voltage is applied between the drain electrode 46 and the source electrode 47 under such a condition, a current is not almost flowed.

In the case that the p-type layer 45 is not used, since two-dimensional electron gas is formed at a boundary between the undoped layer 43 and the undoped layer 44, a current is flowed if a voltage is applied between the drain electrode 46 and the source electrode 47. Moreover, as to whether or not the two-dimensional electron gas is formed, it is realized by controlling: acceptor density and film thickness of the p-type layer 45; film thickness of the undoped layer 44 and density of residual impurity included in a material (for example, AlGaN) consisting of the undoped layer 44; and the undoped layer 45.

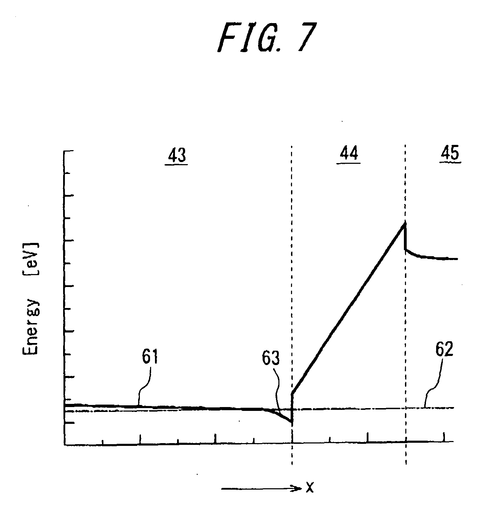

Then, Fig. 7 is a schematic view showing energy distribution of the conduction band, when a light having energy larger than band gap energy of an undoped layer 44 is incident, in the structure of Fig. 5 illustrated as the first embodiment. By means of the depleted layer generated by irradiating a light, electron is exited in the conduction band 61 from the valence band, and an electron-hole pair is generated. The band structure is changed in accordance with the electron-hole pair thus generated, thereby a portion having energy lower than the quasi-Fermi level 62 is generated at a boundary between the undoped layer 43 and the undoped layer 44, and thus the two-dimensional electron gas 63 is formed.

Since the two-dimensional electron gas 63 is served as a channel, a large current is flowed when a voltage is applied between the drain electrode 46 and the source electrode 7. Therefore, in the first embodiment mentioned above, it is possible to realize an ideal ultraviolet light receiving element in which a current is not flowed if a light is not irradiated, and in which a current is flowed if a light is irradiated. Moreover, in the first embodiment, a light is served for changing a band structure located directly below the p-type layer 45, and the number of photons increases a current value as compared with the element affecting a current, as is the same as the pin photodiode. In this case, in order to extend the depleted layer toward the undoped layer, it is necessary to make a carrier density ratio between the p-layer and the n-layer larger, and it is important to make a carrier density difference over double digits.

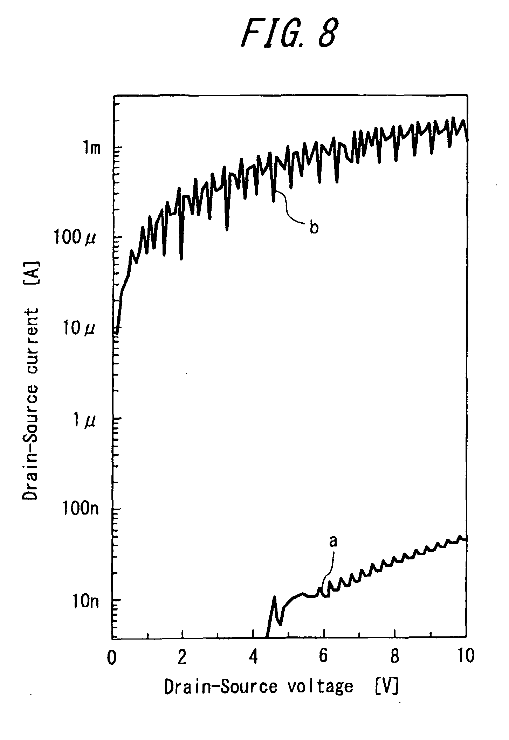

Fig. 8 is a schematic view showing a relation between source-drain voltage and source-drain current of the ultraviolet light receiving element according to the first embodiment. In the case such that a light (for example, light having wavelength of 254 nm) having energy larger than the band gap energy of the undoped layer 44 is not irradiated, a flowing current is under 100 nA as shown in a curve a. On the other hand, in the case such that a light (for example, light having wavelength of 254 nm) having energy larger than the band gap energy of the undoped layer 44 is irradiated, a flowing current is about 1 mA as shown in a curve b. Therefore, in the ultraviolet light receiving element according to the first embodiment, it is possible to improve a light current by over triple digits as compared with the known pin photodiode in which a current flowing when a light is irradiated is below a few µA. These features are remarkably suitable as an ultraviolet light receiving element for detecting a weak ultraviolet light such as a flame sensor or a medical sensor.

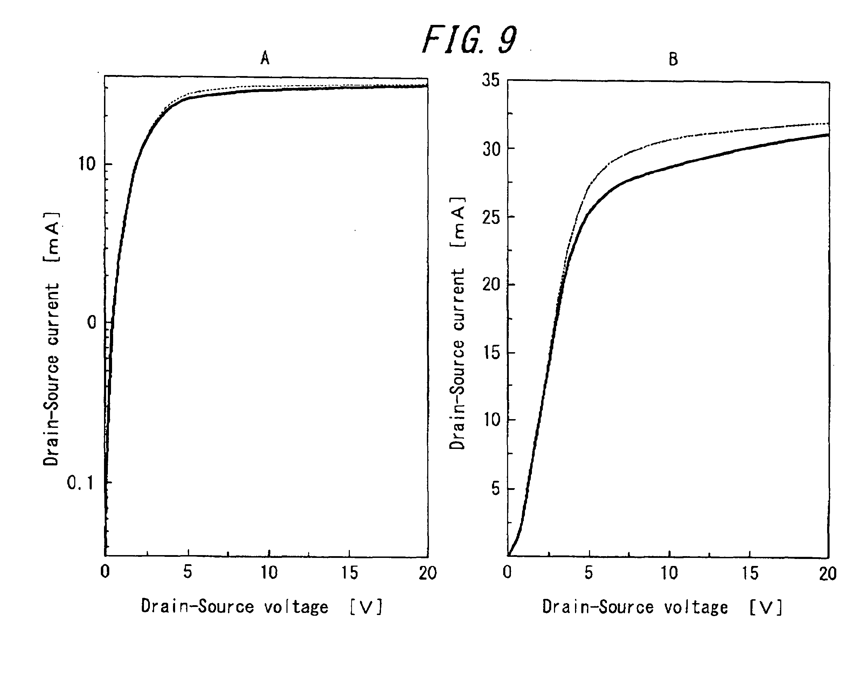

In the case such that the p-type layer 45 is not used, if a light (for example, light having wavelength of 254 nm) having energy larger than the band gap energy of the undoped layer 44 is not irradiated, a flowing current becomes about 10 mA (referred to Fig. 9A). On the other hand, if a light (for example, light having wavelength of 254 nm) having energy larger than the band gap energy of the undoped layer 44 is irradiated, a flowing current attains up to about 30 mA. Therefore, in the case such that the p-type layer 45 is not used, it is difficult to realize an excellent light-dark ratio, and thus it is difficult to make a light receiving sensitivity higher.

In this embodiment, the gate electrode 48 is formed on a part or a portion located directly on the p-type layer 45. However, the same effects can be obtained for the structure in which the gate electrode 48 is formed on an overall surface of the p-type layer 45 or in which the gate electrode 48 is not used. Moreover, as the gate electrode 48 formed on the p-type layer 45, it is effective to use an electrode through which an ultraviolet light is transmitted such as an ITO or a very thin metal electrode having a thickness of a few nm, and further it is very effective to form the gate electrode 48 by a mesh structure. Moreover, as materials of the drain electrode 46 and the source electrode 47, use may be made of every kind of metals if an ohmic property can be obtained, but it is preferred to use Ti, Al, Au, Ta and W among them.

On the other hand, as a material of the gate electrode 48 formed on the p-type layer 45, it is preferred to be an ohmic contact, but use is made of a Shottky contact, and thus arbitral electrode materials may be used. Moreover, it is effective to arrange an insulation film such as SiO₂ or SiNₓ between the electrodes or to form a semiconductor on the p-type layer 45, since it is possible to reduce a dark current.

Further, it is effective to add intentionally impurity to the undoped layer 44. Especially, by doping Si or Ge, there is an effect to increase the two-dimensional electron gas 63 generated when a light is irradiated, and thus it is possible to improve properties of the ultraviolet light receiving element.

Moreover, in the case such that impurity is added to the undoped layer 44, it is effective to sandwich an undoped spacer layer (for example, AlGaN spacer layer) and also it is effective to form a quantum well structure or a heterostructure in AlGaN. Further, it is possible to set arbitrarily the doping density mentioned above, but it is preferred to control a donor density under 1×10¹⁹ [cm⁻³].

Furthermore, in the case such that the p-type layer 45 is constructed by GaN, use is made of a whole carrier density of 1×10¹⁸ [cm⁻³] and an acceptor density of 3×10¹⁹ [cm⁻³] in the first embodiment. In this case, it is important to be p-type, and thus a carrier density, an acceptor density and a film thickness may be arbitrarily set. Moreover, as to the film thickness, if it is maintained over 1 nm thickness, it is possible to realize a target device property

In this case, the undoped layer 43 is constructed by GaN as an underlayer, but impurity such as Mg, carbon and so on may be added therein. Moreover, the same effects may be obtained if a substrate other than sapphire substrate is used. In this case, if group III nitride semiconductor such as SiC, Si, ZrB2, AlN, GaN, AlGaN and so on may preferably be grown, the same effects can be realized even though any substrates may be used.

Moreover, use may be made of a mixed crystal including AlN and InN in spite of the p-type layer 45 made of GaN. In the same manner, if AlN and InN may be included in all the layers, it is possible to realize a high-performance ultraviolet light receiving element. Moreover, in the structure according to the first embodiment, in order to improve the properties, it is effective to use a layer having high carrier density to portions of the drain electrode 46 and the source electrode 47. Further, it is more effective to use a method for injecting ion selectively only to a layer to be contacted, or, to use a method for forming an n-type layer having high density by means of a selective growth, or, to use a method for inserting a thin n-type layer (AlGaN or GaN) having high donor density by means of for example a crystal growth.

Moreover, in the first embodiment mentioned above, the structure is manufactured by organometal vapor growth method. However, if the structure in which a n-type GaN semiconductor layer is made to a drain-source and a p-type GaN semiconductor layer is made to a gate electrode may be realized, the same effects can be obtained even if the other methods such as molecular beam epitaxy, ion-implantation technique and so on are used. Further, in the structure according to the first embodiment mentioned above, use is made of the heterojunction. However, it is not necessary to use especially heterojunction, and use may be made of a homojunction.

Moreover, in the first embodiment mentioned above, the structure may be realized by depositing the undoped layer 44 and the p-type GaN layer 45 on the undoped layer 43. However, the same effects may be obtained even if the n-type layer and the p-type layer are exchanged, and the structure may be operated as a high-performance ultraviolet light receiving element. Further, in the first embodiment mentioned above, in order to form the drain electrode 46 and the source electrode 47, the undoped layer 44 is exposed by the etching process. However, any methods may be used for this purpose, and it is possible to use a method for utilizing for example a selective lateral direction growth, a method for inversing the p-type layer into the n-type layer by an ion implantation.

Moreover, a light may be incident from a top side or a substrate side of the device, and use may be made of one of both sides inn the same manner. Further, a semiconductor DBR or a dielectric multilayer film may be constructed and then a light may be confined, so that it is possible to realize a high-performance of the device. Furthermore, in the first embodiment, an explanation is made to the case such that a strip structure is used for the electrode structure, but any electrode structure other than the stripe structure may be used in the same manner to obtain predetermined properties.

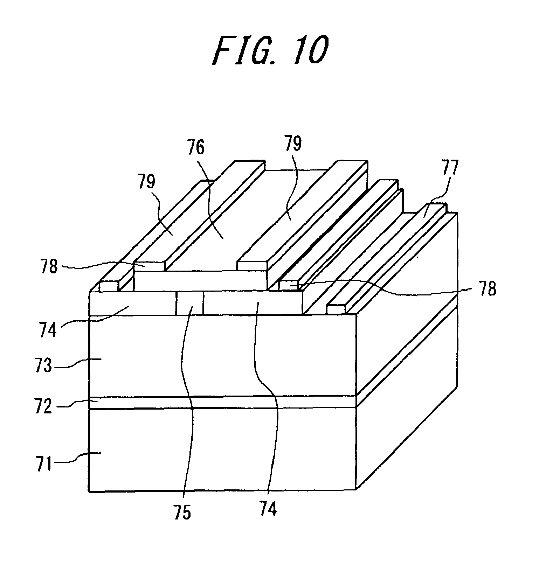

Fig. 10 is a schematic view showing an element structure of a second embodiment of the ultraviolet light receiving element according to the invention. By means of organometal compound vapor growth method, a buffer layer 72 (for example, low-temperature AlN buffer layer) is formed on a substrate 71 (for example, sapphire substrate) at about 500 °C by a crystal growth. Then, a first n-type layer 73 added Si therein (for example, n-type GaN layer) (Si density of 5×10¹⁸ cm⁻³) is grown by about 3 µm by using SiH₄ diluted by H₂ at about 1000 °C. Then, a p-type layer 74 added Mg therein (for example, n-type GaN layer) (Mg density of 3×10¹⁹ cm⁻³) is grown by about 0.5 µm.

Then, by using a photolithography method and a reactive ion etching method utilizing for example Cl₂ gas, a recess portion having a stripe shape with a width of 200 nm is formed in a part of the p-type layer 74. The recess portion is preferably formed by completely etch the p-type layer 74, and thus the n-type layer 73 is exposed. Then, after a suitable semiconductor substrate processing is performed such as a washing method using aqua regalis, nitric acid, sulfuric acid, and organic materials, an undoped layer 75 (for example, undoped GaN layer) is grown by 0.5 µm by using the organometal compound vapor growth method again. Then, a second n-type layer 76 added Si therein (for example, n-type GaN layer) (Si density of 5×10¹⁸ cm⁻³) is grown by about 0.5 µm.

After the specimen manufactured in the manner mentioned above is subjected to a heat treatment in a nitrogen atmosphere at 700 °C for 5 minutes, a part of the p-type layer 74 and a part of the first n-type layer 73 are exposed by using a photolithography apparatus and a reactive ion etching apparatus. Then, a drain electrode 77 made of Ti/Al is formed on the first n-type layer 73, and a gate electrode 78 made of Ni/Au is formed on the p-type layer 74 successively. Then, source electrodes 79 made of Ti/Al are formed on the second n-type layer 76. After that, the ultraviolet light receiving element can be obtained.

In this case, the source electrodes 79 may be preferably formed on a portion other than the portion directly located on the undoped layer 75 as shown in Fig. 10. Moreover, in order to extend a current, it is effective to form a mesh electrode or an opaque electrode directly on the undoped layer 75.

In the second embodiment, when a gate voltage is 0V, an acceptor density of the p-type layer 74 is to be 3×10¹⁹ cm⁻³ and an electron density of the undoped layer 75 is to be 1×10¹⁷ cm⁻³. In this case, the depleted layer is extended in the undoped layer 75 due to the p-type layer 74, and the undoped layer 75 becomes completely the depleted layer in the case of manufacturing the device with a width mentioned above.

Therefore, under the condition such that the gate voltage is made to be 0V without irradiating a light, a leak current due to the drain is to be about 100 mA when a voltage of 20V is applied between the drain electrode 77 and the source electrode 79. In this case, a dark current is extraordinarily low, since use is made of the gate utilizing pn junction.

Then, if a light having energy larger than that of the band gap energy of the semiconductor used for this element is irradiated, there occurs a state such that a part of or all of the undoped layer 75 does not become the depleted layer. Under such a condition, if a voltage is applied between the drain electrode 77 and the source electrode 79, it is possible to flow a current. That is, it is possible to perform an operation of the ideal ultraviolet light receiving element, in which a current is not flowed when a light is not irradiated and a current is flowed when a light is irradiated.

Moreover, in the second embodiment, a width of the stripe structure is set to be 200 nm, but it is possible to set such a width to any suitable value in accordance with an acceptor density of the p-type layer 74 and an electron density of the undoped layer 75. Further, even if the other impurity such as Si, Ge, C and so on is intentionally added, the element is operated as a transistor. In this case, if the device is designed with taking into consideration of an extended area of the depleted layer, it is possible to manufacture the device having predetermined properties.

As an advantage of this structure, a multi channel is easily performed. Therefore, an area for receiving a light can be extended and an ultraviolet light receiving sensitivity can be improved. Moreover, in the second embodiment, the sapphire substrate 71 is explained as an example. As to the substrate, the same effects can be realized by using any other substrates, if a GaN group semiconductor such as SiC, Si, ZrB₂, AlN, GaN, AlGaN and so on can be grown.

Moreover, as a technique for realizing a further high-performance of the device and a technique for forming easily the device, it is effective to use a substrate peeling-off technique such as laser lift-off and so on, which is widely used for a GaN group light-emitting diode. In addition, it is effective to form the drain electrode 77 formed on the first n-type layer 73 on a peeled-ff rear surface or a rear surface of the substrate, in the case such that use is made of the substrate having a conductivity such as SiC substrate, ZrB₂ substrate, GaN substrate and so on.

Moreover, properties of the p-type layer 74 are not varied, even if use is made of a mixed crystal including AlN and InN. In this case, if AlN is included, it is possible to selectively receive a light having a short wavelength. Further, if InN is included, it is possible to realize the element having sensitivity for a visible light. Similarly, in all the layers such as the first n-type layer 73, the undoped layer 75, the second n-type layer 76 and so on, it is possible to realize an ultraviolet light receiving element even if AlN or InN is included therein. Moreover, it is effective to improve properties of the device, if there is a hetero junction in respective layers.

In the second embodiment, use is made of Ni/Au or Ti/Al as the electrode material, but any materials may be used for the electrode. In this case, it is preferable to use the electrode material including Ti, Al, Au, W and so on. Moreover, in the second embodiment, in order to improve the properties, it is effective to use the layer having a high carrier density as the drain electrode 77 and the source electrode 79. It is more effective to use a method for injecting ion selectively for a layer to which an electric contact may be performed, a method for forming the n-type layer having high density by means of a selective growth, and a method of inserting the thin p-type layer.

Moreover, in the second embodiment, the organometal compound vapor growth method is used. However, the ultraviolet light receiving element having the same properties may be realized, if use is made of molecular beam epitaxy, ion-implantation technique and so on. Further, in the second embodiment, the p-type layer 74 is formed at first, and then a predetermined structure can be obtained by repeating the crystal growth. However, the predetermined structure may be realized by the other various methods, and use may be made of the method for inverting the n-type layer to the p-type layer by means of the selective growth method, the Mg ion implanting method, and so on. In this case, it is sufficient to have the structure such that a different polarity layer is used for the gate layer to generate the depleted layer, and a current is controlled by the depleted layer thus generated.

Moreover, in the second embodiment, the channel layer in which a current is flowed is manufactured by the n-type layer. However, when the p-type layer is used for the channel layer, it is possible to construct the semiconductor transistor if the n-type layer is used for the gate. Further, in the second embodiment, p-type layer 74 is formed by the first crystal growth, and after that the undoped layer 75 and the second n-type layer 76 are formed by the second crystal growth. However, the same properties can be obtained, if the undoped layer 75 and the second n-type layer 76 are formed by the first crystal growth and the p-type layer 74 is formed by the second crystal growth.

Moreover, if a light is confined in the element by means of the semiconductor DBR or the dielectric multilayer film, it is possible to effect a high-performance operation. Further, in the second embodiment, use is made of the stripe structure as the electrode structure, but it is possible to obtain predetermined properties even by the any other structures.

## Claims

1. An ultraviolet light receiving element comprising:
a substrate;
a first layer formed by a GaN group semiconductor and arranged on said substrate;
a second layer having the same conductive type as that of said first layer, which is formed by a GaN group semiconductor to be contacted with said first layer and to include a source region, a drain region and a channel region; and
a third layer having a p-type, which is formed by a GaN group semiconductor to be contacted with said second layer and to include a gate region.

2. The ultraviolet light receiving element according to claim 1, wherein said first layer is formed by GaN and said second layer is formed by AIGaN so that a GaN/AlGaN hetero junction is formed by said first layer and said second layer.

3. The ultraviolet light receiving element according to claim 1 or 2, wherein a doping is performed with respect to said second layer.

4. The ultraviolet light receiving element according to claim 3, wherein an undoped spacer layer intervenes in said second layer, or, a quantum well structure or a heterostructure is formed in said second layer.

5. The ultraviolet light receiving element according to one of claims 1 - 4, further forming an optical confinement structure.

6. The ultraviolet light receiving element according to claim 5, wherein said optical confinement structure is constructed by a semiconductor DBR or a dielectric multiplayer film.

7. The ultraviolet light receiving element according to one of claims 1 - 6, wherein said first layer is made to be an undoped layer or a layer having a doped density of not more than 1×10¹⁸ cm⁻³.

8. The ultraviolet light receiving element according to one of claims 1 - 7, wherein said third layer is made to be an acceptor density of not less than 1×10¹⁸ cm⁻³.
